# EUROPÄISCHE PATENTSCHRIFT

(11) **EP 2 811 469 B1**
(45) Veröffentlichungstag und Bekanntmachung des Hinweises auf die Patenterteilung: **30.12.2020**
(21) Anmeldenummer: 13170727.5
(22) Anmeldetag: 06.06.2013
(51) Int. Cl.: G07C 9/00

(54) **Schließeinrichtung**
Closing device
Dispositif de fermeture

(43) Veröffentlichungstag der Anmeldung: 10.12.2014
(73) Patentinhaber: BKS GmbH, 42549 Velbert (DE)
(72) Erfinder: Lelie, Christoph, 45136 Essen (DE); Braam, Reinhold Dr., 46414 Rhede (DE)
(74) Vertreter: DREISS Patentanwälte PartG mbB

(56) Entgegenhaltungen:
- WO-A1-2005/057388
- WO-A2-2006/056424
- DE-B1- 2 453 307
- US-A1- 2004 222 876
- US-A1- 2008 024 312
- US-A1- 2009 256 677

## Beschreibung

Die Erfindung betrifft eine Schließeinrichtung mit mindestens einem elektronischen Verbraucher, insbesondere einer Steuereinrichtung. Die Erfindung betrifft ferner ein Verfahren zum Betreiben einer derartigen Schließeinrichtung.

Es ist bereits bekannt, Schließeinrichtungen wie beispielsweise Schließzylinder für Türen mit elektrischen Komponenten zu versehen, die zum Beispiel eine Benutzeridentifikation im Sinne einer Zutrittskontrolle ausführen können. Nachteilig an den bekannten Systemen ist der verhältnismäßig große elektrische Energiebedarf der elektronischen Komponenten, so dass die bekannten Systeme bei Batteriebetrieb nur eine verhältnismäßig geringe Betriebsdauer bieten.

US 2009/256677 A1 beschreibt ein passives Zugangssystem, bei dem ein kapazitiver Näherungssensor verwendet wird.

WO 2005/057388 beschreibt eine Aufwecksignal-Detektorschaltung.

DE 24 533 07 B1 beschreibt eine Schaltungsanordnung zur Pegelüberwachung eines Datensignals.

WO 2006/056424 A2 beschreibt eine Schließanordnung. US 2008/024312 A1 beschreibt einen elektrischen Schaltkreis. US 2004/222876 A1 beschreibt einen energiesparenden elektrischen Schaltkreis für ein elektrisches Schloss.

Es sind ferner Ansätze bekannt, bei denen an der Schließeinrichtung ein elektromechanisches Schaltglied, wie beispielsweise ein Taster, vorgesehen ist, der zunächst durch eine Person betätigt werden muss, bevor die Schließeinrichtung beziehungsweise eine darin enthaltene Elektronik aus einem Energiesparzustand in einen regulären Betriebszustand versetzt wird. Diese Systeme weisen zwar einen verringerten mittleren Energieverbrauch auf, erfordern jedoch eine verhältnismäßig umständliche Bedienung.

Demgemäß ist es Aufgabe der vorliegenden Erfindung, eine Schließeinrichtung und ein Betriebsverfahren für eine Schließeinrichtung dahingehend zu verbessern, dass ein geringerer mittlerer Energieverbrauch und gleichzeitig eine einfachere und komfortablere Handhabbarkeit gegeben sind.

Diese Aufgabe wird durch die Merkmalskombination gemäß Anspruch 1 gelöst.

Erfindungsgemäß ist erkannt worden, dass eine Steuerschaltung zur Erkennung einer Betriebssituation, die ein Aktivieren der Steuereinrichtung der Schließeinrichtung, beispielsweise aus einem Energiesparzustand heraus, erfordert, besonders stromsparend ausgebildet werden kann, wenn Sie ein elektrisches Feld bzw. eine zeitliche Änderung des elektrischen Felds als Auswertungsprinzip verwendet.

Bei einer besonders bevorzugten Ausführungsform ist vorgesehen, dass die Steuerschaltung dazu ausgebildet ist, ein elektrisches Feld und/oder eine zeitliche Änderung des elektrischen Feldes, insbesondere im Bereich der Schließeinrichtung, zu erfassen.

Bei einer weiteren Ausführungsform ist vorgesehen, dass die Steuerschaltung dazu ausgebildet ist, eine das elektrische Feld und/oder die zeitliche Änderung des elektrischen Felds charakterisierende Größe zu erfassen.

Vorteilhaft kann eine elektronische Schaltungsanordnung zur Erfassung des elektrischen Felds bzw. einer das elektrische Feld charakterisierenden Größe Untersuchungen der Anmelderin zufolge so ausgebildet sein, dass sie, insbesondere im Vergleich zu anderen Detektionsprinzipien wie z.B. PIR (passiv-Infrarot), RFID (radio frequency identification) oder kapazitiven bzw. induktiven Sensoren mit Schwingkreis, eine sehr geringe elektrische Leistungsaufnahme aufweist, wodurch insbesondere bei batteriebetriebenen Einrichtungen eine gesteigerte Betriebsdauer bzw. größere Serviceintervalle erhalten werden.

Bei einer Ausführungsform können ein oder mehrere der nachfolgend genannten Prinzipien zur Betätigung der erfindungsgemäßen Schließeinrichtung verwendet bzw. ausgenutzt werden: Außerhalb von Gebäuden besteht eine vertikale Potentialdifferenz von etwa 100 Volt pro Meter bis etwa 300 Volt pro Meter, bei Gewitter sogar bis zu etwa 35 Kilovolt pro Meter. Eine sich der erfindungsgemäßen Schließeinrichtung nähernde Person bewirkt eine Verformung des elektrischen Feldes im Bereich der Schließeinrichtung, welche einer Ausführungsform zufolge in eine Spannungsänderung einer Schaltungskomponente der Schließeinrichtung transformiert werden kann. Auf diese Weise ist durch die Erkennung des elektrischen Feldes bzw. seiner zeitlichen Änderung eine Annäherung einer Person an die Schließeinrichtung detektierbar. Das Prinzip funktioniert ebenso in Gebäuden, auch geschlossenen Gebäuden, wobei die Potentialdifferenz dort von Freiraumbedingungen abweicht bzw. sich eine andere Feldverteilung ergibt als außerhalb von Gebäuden.

Ein weiterer Effekt, der für den Betrieb der erfindungsgemäßen Schließeinrichtung ausgenutzt werden kann, besteht darin, dass eine Person, die sich dem Sensor nähert, aufgrund einer bestimmten Beschaffenheit des Fußbodens bzw. von Schuhsohlen und dergleichen eine elektrostatische Ladung aufbaut bzw. mit sich trägt. Bei einer besonders bevorzugten Ausführungsform ist eine derartige elektrostatische Ladung bzw. eine hierdurch verursachte Feldverzerrung im Bereich der Schließeinrichtung durch die erfindungsgemäße Schließeinrichtung erkennbar, wodurch ebenfalls der elektronische Verbraucher an einem ersten Betriebszustand in einen zweiten Betriebszustand versetzt werden kann.

Als weiterer Effekt kommt die Verwendung von RFID- (Radio Frequency Identification) Ausweisen oder dergleichen in Frage, wobei die RFID Ausweise üblicherweise als Kunststoffkarte im Kreditkartenformat ausgebildet sind. Die RFID-Ausweise weisen Untersuchungen der Anmelderin zufolge eine erhebliche elektrostatische Ladung an ihrer Oberfläche auf, so dass sie bei Annäherung ebenfalls eine Feldverzerrung im Bereich der erfindungsgemäßen Schließeinrichtung und damit eine Erkennung der Feldveränderung durch die Schließeinrichtung bewirken können.

Die vorstehend genannten Effekte können erfindungsgemäß vorteilhaft durch die Schließeinrichtung verwendet werden, beispielsweise um den elektronischen Verbraucher der Schließeinrichtung von einem Schlaf- bzw. Energiesparmodus, in dem er eine besonders geringe elektrische Leistung aufnimmt, in einen Bereitschaftsmodus bzw. in einen normalen Betriebszustand zu versetzen.

Weiter ist vorgeschlagen, dass eine Messelektrode vorgesehen ist, und eine Eingangsverstärkereinrichtung, welche dazu ausgebildet ist, ein Ausgangssignal der Messelektrode zu verstärken. Dadurch kann beispielsweise eine Änderung des elektrischen Feldes im Bereich der Schließeinrichtung bzw. im Bereich der Messelektrode transformiert werden in eine entsprechende elektrische Spannung bzw. eine zeitliche Änderung einer elektrischen Spannung. Alternativ oder ergänzend ist auch eine Strommessung einsetzbar. Das Ausgangssignal der Messelektrode gemäß der vorliegenden Ausführungsform kann also eine zeitlich veränderliche elektrische Spannung (bzw. Strom) sein, wobei die zeitliche Veränderung der elektrischen Spannung eine entsprechende Veränderung des elektrischen Feldes charakterisiert.

Weiter ist vorgesehen, dass eine Übertragungsfunktion der Eingangsverstärkereinrichtung eine Bandpasscharakteristik aufweist, insbesondere mit einer Mittenfrequenz von etwa 0,5 Hz, oder eine Tiefpasscharakteristik, insbesondere mit einer Grenzfrequenz von etwa 1,5 Hz. Dadurch ist vorteilhaft sichergestellt, dass eine zuverlässige Erkennung der Annäherung einer Person, welche beispielsweise die Schließeinrichtung zu betätigen wünscht, ermöglicht ist.

Besonders vorteilhaft werden höherfrequente Störeinstrahlungen durch die in der vorliegenden Ausführungsform vorgesehene Filtercharakteristik bzw. ihr Effekt auf die entsprechende Signalverarbeitung der Steuerschaltung reduziert.

Bei einer weiteren vorteilhaften Ausführungsform ist vorgesehen, dass die Eingangsverstärkereinrichtung mindestens eine Tiefpassschaltung aufweist, welche eine Parallelschaltung aus einem kapazitiven Element und einem resistiven Element (beispielsweise Ohmscher Widerstand) aufweist, wobei vorzugsweise ein Widerstandswert des resistiven Elements im Bereich von etwa 1 Gigaohm (GΩ) bis 100 Gigaohm, insbesondere im Bereich von etwa 40 Gigaohm bis etwa 60 Gigaohm, liegt und wobei vorzugsweise ein Kapazitätswert des kapazitiven Elements im Bereich von etwa 0,2 Pikofarad (pF) bis etwa 500 Pikofarad liegt, insbesondere im Bereich von etwa 5 Pikofarad bis etwa 20 Pikofarad. Ein Widerstandswert für das resistive Element von etwa 50 GΩ und ein Kapazitätswert für das kapazitive Element von etwa 10 pF hat sich einer Ausführungsform zufolge als besondere vorteilhaft herausgestellt, weil einerseits die gewünschte Tiefpasscharakteristik erhalten wird und andererseits aufgrund des hochohmigen resistiven Elements eine außerordentlich geringe Belastung eines elektrischen Signals, welches von der Messelektrode geliefert wird, gegeben ist.

Bei einer weiteren bevorzugten Ausführungsform ist eine Auswerteinrichtung vorgesehen, welche dazu ausgebildet ist, ein das elektrische Feld und/oder die zeitliche Änderung des elektrischen Feld charakterisierendes Auswertsignal auszuwerten, wobei die Auswerteinrichtung insbesondere dazu ausgebildet ist, in Abhängigkeit des Auswertsignals ein, insbesondere zweiwertiges (binäres), Steuersignal, auszugeben. Das Steuersignal kann einer Ausführungsform zufolge vorteilhaft dazu verwendet werden, den elektronischen Verbraucher von einem ersten Zustand in einen zweiten Zustand zu versetzen. Beispielsweise kann das Steuersignal direkt mit einem Interrupt-Eingang eines gängigen Mikrokontrollers verbunden werden, um den Mikrokontroller durch Auslösung eines Interrupts in an sich bekannter Weise aus einem Energiesparzustand in einen Normalbetriebszustand zu versetzen.

Der Auswerteinrichtung kann als Auswertsignal eingangsseitig beispielsweise das von der Eingangsverstärkereinrichtung gemäß einer der vorstehend beschriebenen Ausführungsformen erzeugte und verstärkte Eingangssignal zugeführt werden. Alternativ oder ergänzend kann der Auswerteinrichtung eingangsseitig auch ein aus dem verstärkten Eingangssignal abgeleitetes Signal (z.B. weiter gefiltert bzw. geglättet oder dergleichen) zugeführt werden.

Bei einer weiteren vorteilhaften Ausführungsform ist vorgesehen, dass die Auswerteinrichtung eine Diskriminatorschaltung aufweist, wobei die Diskriminatorschaltung eine Serienschaltung aus einem ersten resistiven Element, einer Diodenbrückenschaltung und einem zweiten resistiven Element aufweist, wobei die Serienschaltung zwischen einem ersten Bezugspotential und einem zweiten Bezugspotential angeschlossen ist. Dies erlaubt eine besonders präzise Auswertung einer das elektrische Feld charakterisierenden Größe bei gleichzeitig geringer elektrischer Energieaufnahme.

Bei einer weiteren vorteilhaften Ausführungsform ist vorgesehen, dass die Diodenbrückenschaltung eine Parallelschaltung aufweist aus zwei jeweils zwei Dioden aufweisenden Diodenserienschaltungen, wobei einem Schaltungsknoten zwischen den Dioden einer ersten der beiden Diodenserienschaltungen das Auswertsignal zugeführt ist, und wobei ein Schaltungsknoten zwischen den Dioden einer zweiten der beiden Diodenserienschaltungen mit einem dritten Bezugspotential verbunden ist. Auf diese Weise kann z.B. eine elektrische Spannung bzw. ein elektrisches Potential, das das zu erfassende elektrische Feld charakterisiert, besonders präzise ausgewertet werden, und es können vorteilhaft sowohl positive als auch negative Spannungen erfasst werden. Bei einer besonders bevorzugten Ausführungsform liegt das dritte Bezugspotential zwischen dem ersten und dem zweiten Bezugspotential, insbesondere etwa in der Mitte des ersten und des zweiten Bezugspotentials.

Bei einer weiteren vorteilhaften Ausführungsform ist vorgesehen, dass die Diodenbrückenschaltung zwischen dem ersten resistiven Element und dem zweiten resistiven Element geschaltet ist.

Bei einer weiteren vorteilhaften Ausführungsform ist vorgesehen, dass eine Verstärkereinrichtung mit ihrem Eingang parallel zu der Diodenbrückenschaltung geschaltet ist. Auf diese Weise kann vorteilhaft das von der Diodenbrückenschaltung gelieferte Ausgangssignal verstärkt werden, so dass es direkt z.B. zur Ansteuerung eines Mikrocontrollers verwendbar ist.

Bei einer weiteren vorteilhaften Ausführungsform ist vorgesehen, dass das erste und/oder zweite resistive Element einen Widerstandswert von mindestens etwa 1 Megaohm (MΩ) aufweist, vorzugsweise von mindestens etwa 10 Megaohm, so dass auch die die Diodenbrückenschaltung aufweisende Serienschaltung außerordentlich hochohmig ist und damit eine nur geringe elektrische Leistung erfordert. Gleichwohl ermöglicht die bei dieser Ausführungsform vorgeschlagene Schaltungstopologie die Auswertung bipolarer Spannungen und einen großen Dynamikbereich.

Bei einer weiteren vorteilhaften Ausführungsform ist vorgesehen, dass eine Bezugspotentialerzeugungsvorrichtung vorgesehen ist, welche dazu ausgebildet ist, mindestens ein drittes elektrisches Bezugspotential in Abhängigkeit eines ersten und zweiten elektrischen Bezugspotentials bereitzustellen. Auf diese Weise kann die erfindungsgemäße Schließeinrichtung mit einer einfachen handelsüblichen Spannungsversorgung (z.B. Batterie, Lithiumzelle, usw.) betrieben werden, und dennoch ist die Auswertung bipolarer Signale bzw. eine Versorgung von Schaltungskomponenten wie z.B. Operationsverstärkern usw. mit einer bipolaren Spannung möglich. Bei einer besonders bevorzugten Ausführungsform liegt wie bereits beschrieben das dritte Bezugspotential zwischen dem ersten und dem zweiten Bezugspotential, insbesondere etwa in der Mitte des ersten und des zweiten Bezugspotentials.

Bei einer weiteren vorteilhaften Ausführungsform ist vorgesehen, dass die Bezugspotentialerzeugungsvorrichtung eine Serienschaltung aus mindestens zwei resistiven Elementen aufweist, wobei das erste und/oder zweite resistive Element der Bezugspotentialerzeugungsvorrichtung einen Widerstandswert von mindestens etwa 1 Megaohm aufweist, vorzugsweise von mindestens etwa 10 Megaohm. Damit trägt auch die Bezugspotentialerzeugungsvorrichtung vorteilhaft zur geringen elektrischen Leistungsaufnahme der Schließeinrichtung bei.

Als eine weitere Lösung der Aufgabe der vorliegenden Erfindung ist ein Verfahren gemäß Patentanspruch 142 angegeben. Weitere vorteilhafte Ausführungsformen sind Gegenstand der Unteransprüche.

Nachfolgend werden beispielhafte Ausführungsformen der Erfindung unter Bezugnahme auf die Zeichnung erläutert. In der Zeichnung zeigt:
- Figur 1: schematisch eine erste Ausführungsform einer erfindungsgemäßen Schließeinrichtung,
- Figur 2: schematisch ein Blockdiagramm einer erfindungsgemäßen Steuerschaltung für die Schließeinrichtung gemäß Figur 1,
- Figur 3: schematisch eine Schaltungsanordnung gemäß einer Ausführungsform, und
- Figur 4: schematisch eine Schaltungsanordnung gemäß einer weiteren Ausführungsform.

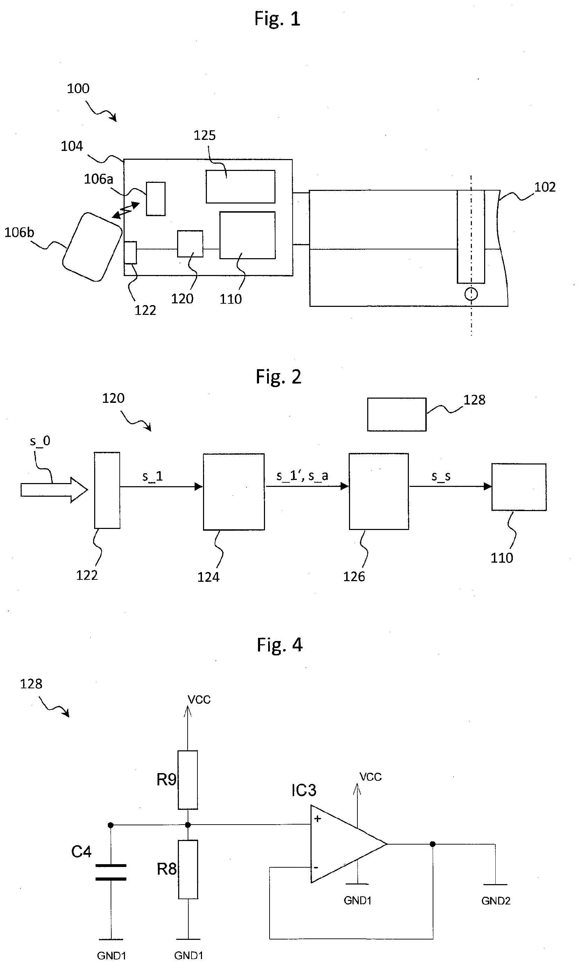

Fig. 1 zeigt schematisch eine Seitenansicht einer als sog. Knaufzylinder ausgebildeten Schließeinrichtung 100, die über einen Schließzylinder 102 und einen mit dem Schließzylinder 102 in an sich bekannter Weise mechanisch gekoppelten Knauf 104 verfügt, der als Betätigungselement für den Schließzylinder 102 dient. Die Schließeinrichtung 100 kann beispielsweise in ein Einsteckschloss für eine Tür (nicht gezeigt) eingebaut und für eine Verriegelung beziehungsweise Entriegelung der Tür verwendet werden.

Die Schließeinrichtung 100 verfügt über mindestens einen elektronischen Verbraucher, bei dem es sich vorliegend um eine elektronische Steuereinrichtung 110 handelt. Die Steuereinrichtung 110 kann beispielsweise eine oder mehrere elektronische Komponenten aufweisen, die einen Betrieb der Schließeinrichtung 100 steuern. Besonders bevorzugt weist die Steuereinrichtung 110 einen in Fig. 1 nicht abgebildeten Mikrocontroller oder eine sonstige Recheneinheit auf, die z.B. Betriebsabläufe der Schließeinrichtung steuern beziehungsweise regeln kann. Die Schließeinrichtung 100 verfügt ferner über eine Kommunikationsschnittstelle, vorliegend z.B. ein RFID-Lesegerät 106a, das in an sich bekannter Weise eine Datenverbindung mit einem kompatiblen RFID-Transponder 106b aufbauen und von diesem Informationen, beispielsweise Identifikationsdaten eines Benutzers, erhalten kann. Über diese RFID-Schnittstelle 106a, 106b können die in dem Transponder 106b enthaltenen Informationen in an sich bekannter Weise drahtlos an die Steuereinrichtung 110 übermittelt werden. Die Steuereinrichtung 110 kann nach dem Erhalt entsprechender Identifikationsdaten eines Transponders 106b beispielsweise eine Zutrittskontrollfunktion ausführen, die die soeben empfangenen Identifikationsdaten mit einer Liste von gespeicherten, zulässigen Identifikationsdaten berechtigter Nutzer abgleicht. Sofern der Transponder 106b als berechtigter Transponder erkannt wird, kann die Steuereinrichtung 110 über eine Aktorik (nicht gezeigt) ein Schließglied des Schließzylinders 102 ansteuern beziehungsweise eine Kupplung, welche eine mechanische Kopplung zwischen dem Betätigungselement 104 und dem Schließglied aktiviert und/oder deaktiviert.

Alternativ oder ergänzend zu einer RFID-basierten Kommunikation können z.B. auch Systeme mit kapazitiver Datenübertragung und/oder allgemeine Funksysteme und/oder optische Kommunikationssystem vorgesehen sein, die beispielsweise modulierte Infrarotsignale verwenden.

Die elektrische Energieversorgung der Komponenten 106a, 110 ist durch eine Batterie 125 gewährleistet, die vorliegend ebenfalls in ein Gehäuse des Betätigungselements 104, also z.B. in den Knauf des Knaufzylinders 100, integriert ist. Damit die Steuereinrichtung 110 und ihr integrierter Mikrocontroller sowie der RFID-Leser 106a und gegebenenfalls weitere elektronische Verbraucher (nicht gezeigt) der Schließeinrichtung 100 nicht permanent aktiviert sein müssen, wodurch sie unnötig die Batterie 125 belasten würden, ist erfindungsgemäß eine Steuerschaltung 120 vorgesehen, die dazu ausgebildet ist, die Steuereinrichtung 110, vorzugsweise jedoch auch die weiteren elektronischen Verbraucher 106a, wahlweise in einen ersten beziehungsweise einen zweiten Betriebszustand oder auch weitere Betriebszustände zu versetzen. Bei dem ersten Betriebszustand handelt es sich bevorzugt um einen Energiesparzustand, in dem die elektronischen Verbraucher eine verhältnismäßig geringe Leistungsaufnahme aufweisen.

Beispielsweise kann bei Verwendung eines Mikrocontrollers in der Steuereinrichtung 110 eine bereits in den Mikrocontroller integrierte Energiesparfunktion dahingehend genutzt werden, dass der Mikrocontroller sich selbst bei Nichtgebrauch beziehungsweise längerer Inaktivität des RFID-Lesers 106a usw. in den Energiesparzustand versetzt. Dieser Mechanismus ist an sich bekannt.

Die erfindungsgemäße Steuerschaltung 120 dient vorteilhaft dazu, den Mikrocontroller beziehungsweise die gesamte Steuereinrichtung 110 sowie gegebenenfalls die weiteren elektronischen Komponenten 106a aus dem Energiesparzustand wieder in einen regulären Energiesparzustand zu versetzen, wenn eine reguläre Funktionsweise der Steuereinrichtung 110 erforderlich ist.

Dies ist beispielsweise dann der Fall, wenn sich ein Benutzer mit seinem Transponder 106b dem Betätigungselement 104 nähert und eine Datenübertragung zwischen dem Transponder 106b und dem Lesegerät 106a sowie eine nachfolgende Auswertung durch die Steuereinrichtung 110 erfolgen soll.

Erfindungsgemäß ist die Steuerschaltung 120 dazu ausgebildet, den elektronischen Verbraucher 110, also die Steuereinrichtung, in Abhängigkeit eines elektrischen Feldes von einem ersten Betriebszustand in einen zweiten Betriebszustand zu versetzen. Wie bereits vorstehend beschrieben kann es sich bei den Betriebszuständen beispielsweise um einen Energiesparzustand sowie einen regulären Betriebszustand oder dergleichen handeln.

Figur 2 zeigt schematisch ein Funktionsdiagramm der erfindungsgemäßen Steuerschaltung 120. Eingangsseitig ist eine Messelektrode 122 zur Detektion eines elektrischen Felds vorgesehen, welche einem elektrischen Feld, zum Beispiel dem elektrischen Feld in der Umgebung der Steuerschaltung 120 bzw. der Schließeinrichtung 100, vorliegend symbolisiert durch den Blockpfeil s_0, ausgesetzt ist. In Abhängigkeit des elektrischen Felds s_0 liefert die Messelektrode 122 dementsprechend ein elektronisches Signal s_1, welches der Steuerschaltung 120 eingangsseitig zugeführt wird.

Die Steuerschaltung 120 verfügt über eine Eingangsverstärkereinrichtung 124, welche das Eingangssignal s_1 von der Messelektrode 122 verstärkt und ein entsprechend verstärktes Signal s_1' an ihrem Ausgang ausgibt. Das verstärkte Eingangssignal s_1' wird nachfolgend auch als Auswertsignal s_a bezeichnet. Das Auswertsignal s_a wird einer Auswerteinrichtung 126 zugeführt, welche dazu ausgebildet ist, das Auswertsignal s_a bzw. seine zeitliche Änderung auszuwerten, insbesondere auf eine charakteristische Änderung des elektrischen Feldes hin, welche z.B. mit der Annäherung einer Person an die erfindungsgemäße Schließeinrichtung 100 korrespondiert.

Besonders bevorzugt ist die Auswerteinrichtung 126 dazu ausgebildet, in Abhängigkeit des Auswertsignals s_a ein, insbesondere zweiwertiges, Steuersignal s_s auszugeben. Das Steuersignal s_s kann bei einer bevorzugten Ausführungsform direkt der Steuereinrichtung 110 (Mikrokontroller) zugeführt werden, beispielsweise einem entsprechenden Interrupt-Eingang (nicht gezeigt) des Mikrokontrollers 110, um diesen durch eine Zustandsänderung des Steuersignals s_s durch das Auslösen eines Interrupts aus einem Energiesparzustand in einen normalen Betriebszustand zu versetzen, in dem der Mikrokontroller 110 eine Datenkommunikation des Transponders 106b (Fig. 1) empfangen bzw. beantworten kann.

Bei einer besonders bevorzugten Ausführungsform ist ferner eine Bezugspotentialerzeugungsvorrichtung 128 vorgesehen, welche dazu ausgebildet ist, in Abhängigkeit von mindestens einem bzw. zwei Eingangsbezugspotentialen mindestens ein weiteres Bezugspotential, welches für den Betrieb von schaltungstechnischen Komponenten beispielsweise der Eingangsverstärkereinrichtung 124 bzw. der Auswerteinrichtung 126 verwendbar ist, zu erzeugen. Dadurch kann die Schließeinrichtung 100 vorteilhaft durch eine handelsübliche Batterie 125 (Fig. 1) betrieben werden, und die Steuerschaltung 120 stellt durch die Bezugspotentialerzeugungsvorrichtung 128 ggf. benötigte weitere Bezugspotentiale bereit.

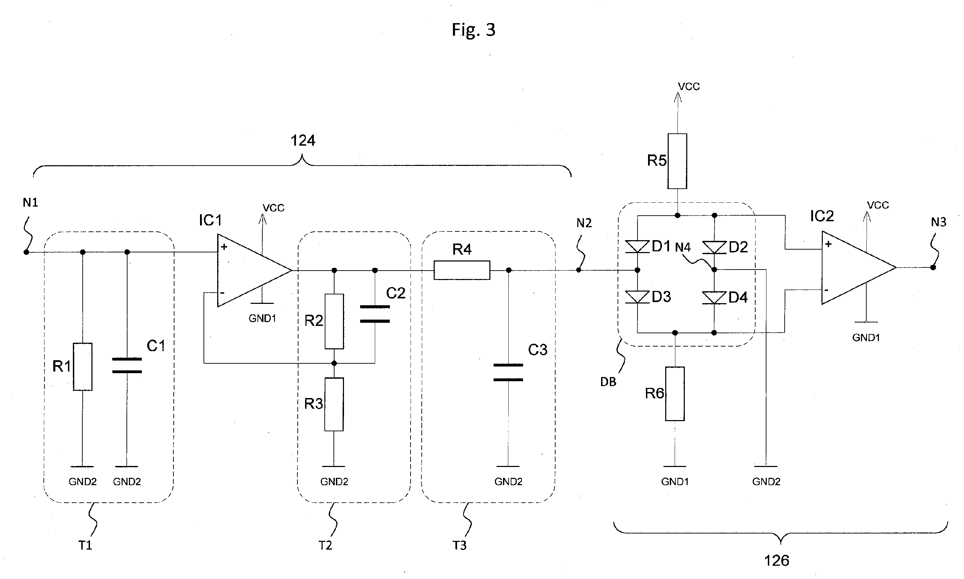

Figur 3 zeigt eine schaltungstechnische Realisierung einer besonders bevorzugten Ausführungsform der Eingangsverstärkereinrichtung 124 (Figur 2) und der Auswerteinrichtung 126.

Die Eingangsverstärkereinrichtung 124 weist einen ersten Schaltungsknotenpunkt N1 auf, an den die Messelektrode 122 (Figur 2) angeschlossen werden kann. Insbesondere wird ein Anschluss der Messelektrode 122 mit dem Schaltungsknotenpunkt N1 verbunden, und ein ggf. vorhandener zweiter Anschluss der Messelektrode wird mit dem ersten Bezugspotential GND1, bei dem es sich bevorzugt um ein Massenpotential der Batterie 125 handeln kann, verbunden.

Eine erste Tiefpassschaltung T1 weist einen ersten Ohmschen widerstand R1 und parallel hierzu einen ersten Kondensator C1 auf, welche beide in der in Figur 3 abgebildeten Weise mit dem ersten Schaltungsknotenpunkt N1 verbunden sind. Die in Figur 3 unteren Anschlüsse der Elemente C1, R1 sind mit einem dritten Bezugspotential GND2 verbunden, das bevorzugt zwischen dem ersten Bezugspotential GND1 (Massepotential) und dem zweiten Bezugspotential VCC liegt. Beispielsweise entspricht das erste Bezugspotential GND1 dem Massepotential der Batterie 125 (Fig. 1) und das zweite Bezugspotential VCC dem Versorgungsspannungspotential der Batterie 125, wohingegen das dritte Bezugspotential GND2 z.B. durch die Bezugspotentialerzeugungsvorrichtung 128 (Fig. 2) erhalten wird.

Die erste Tiefpassschaltung T1 bewirkt eine Filterung der von der Messelektrode 122 gelieferten Signale s_1 (Fig. 2), wobei eine Grenzfrequenz der Tiefpassschaltung T1 besonders bevorzugt im Bereich von etwa 1,5 Hz gewählt ist. Ein besonders bevorzugter Wert für den elektrischen Widerstand des ersten Ohmwiderstands R1 ist etwa 50 GΩ, und ein besonders bevorzugter Wert für den ersten Kondensator C1 ist etwa 10 pF.

Die Eingangsverstärkerschaltung 124 weist ferner eine Verstärkerschaltung IC1 auf, die nicht notwendigerweise als integrierter Schaltkreis ausgebildet ist, besonders bevorzugt jedoch als Operationsverstärker ausgebildet sein kann. Ein Beispiel für einen bevorzugt verwendeten Operationsverstärker ist der Schaltkreis LPV 521 der Firma Texas Instruments.

Die Betriebsspannungsversorgung des Operationsverstärkers IC1 erfolgt derart, dass ein Masseanschluss des Operationsverstärkers IC1 mit dem ersten Bezugspotential GND1 verbunden wird, und ein Betriebsspannungsanschluss für eine positive Betriebsspannung wird mit dem zweiten Bezugspotential VCC verbunden. Das Massepotential GND1 entspricht bei einer bevorzugten Ausführungsform beispielsweise einem Potential von 0 Volt, während das zweite Bezugspotential VCC einem Potential von etwa 3 Volt entspricht. Eine Potentialdifferenz VCC-GND1 beträgt also etwa 3 Volt. Bevorzugt beträgt das dritte Bezugspotential GND2 bei einer Ausführungsform etwa 1,5 Volt.

Bei der in Figur 3 abgebildeten Ausführungsform der Eingangsverstärkerschaltung 124 sind ferner zwei weitere Tiefpassschaltungen T2, T3 vorgesehen, wobei die zweite Tiefpassschaltung T2 mit den Komponenten R2, R3, C2 gleichzeitig zur Rückkopplung eines Teils des Ausgangssignals des Operationsverstärkers IC1 dient, so dass die abgebildete Konfiguration eine Impedanzwandlung vornimmt, wobei ein Verstärkungsfaktor der abgebildeten Schaltung wesentlich durch den Spannungsteiler R2, R3 definiert ist.

Bevorzugte Widerstandswerte für die Ohmwiderstände der zweiten Tiefpassschaltung T2 sind R2 = 1 MΩ, R3 = 220 kΩ. Ein bevorzugter Kapazitätswert ist C2 = 33 nF (Nanofarad). Es ist zu beachten, dass der Widerstand R3 der zweiten Tiefpassschaltung T2 mit seinem in Figur 3 unteren Anschluss mit einem dritten Bezugspotential GND2 verbunden ist, das wie bereits beschrieben bevorzugt insbesondere verschieden ist von dem ersten Bezugspotential GND1. Bei einer besonders bevorzugten Ausführungsform liegt das dritte Bezugspotential GND2 etwa in der Mitte der Bezugspotentiale GND1, VCC.

Eine dritte Tiefpassschaltung T3 nimmt eine weitere Tiefpassfilterung des von dem Operationsverstärker IC1 verstärkten Signals vor. Besonders bevorzugte Bauteilwerte sind R4 = etwa 100 kΩ, C3 = etwa 330 nF. Auch der Kondensator C3 der dritten Tiefpassschaltung T3 ist mit seinem in Figur 3 unteren Anschluss mit dem dritten Bezugspotential GND2 verbunden.

Anstelle der Tiefpassschaltungen T1, T2, T3 sind bei einer weiteren Ausführungsform auch Bandpassschaltungen verwendbar.

Im Falle einer Tiefpasscharakteristik der Übertragungsfunktion der Schaltung 124 beträgt bei einer bevorzugten Ausführungsform eine Grenzfrequenz etwa 1,5 Hz. Im Falle einer Bandpasscharakteristik der Übertragungsfunktion der Schaltung 124 beträgt bei einer weiteren bevorzugten Ausführungsform eine Mittenfrequenz etwa 0,5 Hz.

An dem Schaltungsknotenpunkt N2, der einen Ausgang der Eingangsverstärkereinrichtung 124 darstellt, liegt in einem Ruhezustand ein Potential von etwa GND2 (drittes Bezugspotential) an. Sobald sich eine Änderung des elektrischen Feldes im Bereich der Schließeinrichtung 100 ergibt, wird dies durch die Messelektrode 122 (Figur 2) detektiert und das entsprechende Signal an dem Schaltungsknotenpunkt N1 durch die Eingangsverstärkereinrichtung 124 verstärkt, so dass ein elektrisches Potential an dem zweiten Schaltungsknotenpunkt N2 einen von dem dritten Bezugspotential GND2 verschiedenen Wert annimmt.

Eine derartige Änderung des Potentials an dem zweiten Schaltungsknotenpunkt N2 wird durch die Auswerteinrichtung 126 detektiert, vorzugsweise in ein zweiwertiges Ausgangssignal (s_s aus Figur 2) transformiert und an dem dritten Schaltungsknotenpunkt N3 ausgegeben.

Bei einer bevorzugten Ausführungsform weist die Auswerteinrichtung 126 eine Serienschaltung aus zwei Ohmschen Widerständen R5, R6 sowie einer Diodenbrückenschaltung DB auf, wobei die Diodenbrückenschaltung DB wie aus Figur 3 ersichtlich besonders bevorzugt in der Mitte der Ohmwiderstände R5, R6 angeordnet ist. Der Ohmwiderstand R5 ist mit seinem in Figur 3 oberen Anschluss mit dem zweiten Bezugspotential VCC verbunden, und der zweite Ohmwiderstand R6 der Serienschaltung ist mit seinem in Figur 3 unteren Anschluss mit dem ersten Bezugspotential GND1 verbunden.

Die Diodenbrückenschaltung DB besteht aus zwei zueinander parallel geschalteten Serienschaltungen aus den Dioden D1, D3 bzw. D2, D4.

Der Schaltungsknotenpunkt N2 ist mit dem Verbindungspunkt zwischen den Dioden D1, D3 wie in Figur 3 abgebildet, verbunden, und der Schaltungsknotenpunkt N4 zwischen den Dioden D2, D4 ist mit dem dritten Bezugspotential GND2 verbunden. Besonders bevorzugte Bauteilwerte für die Widerstände R5, R6 sind jeweils etwa 10 MΩ, wodurch sich auch für die Serienschaltung R5, DB, R6 eine besonders hochohmige Konfiguration und damit eine geringe elektrische Energieaufnahme und somit ein entsprechend sparsamer Betrieb, der insbesondere auch für eine Batterieversorgung geeignet ist, ergibt.

Sobald sich wie vorstehend bereits beschrieben das elektrische Potential des zweiten Schaltungsknotenpunkts N2 ändert, ergibt sich eine Unsymmetrie der Potentiale an den Knotenpunkten zwischen den Dioden D1, D3 und D2, D4. Dies führt zu einer Änderung des Spannungsabfalls über der Diodenbrückenschaltung DB, welcher der zweiten Verstärkereinrichtung IC2, bevorzugt wiederum als Operationsverstärker oder als Komparator ausgebildet, zugeführt wird. Der zweite Operationsverstärker IC2 transformiert dementsprechend eine Spannungsänderung an dem Schaltungsknotenpunkt N2 in ein bevorzugt digitales Ausgangssignal an dem Schaltungsknotenpunkt N3, wobei das digitale Ausgangssignal an dem Schaltungsknotenpunkt N3 dann eine Zustandsänderung (z.B. Übergang von "High" nach "Low" oder umgekehrt) erfährt, wenn die Spannungsänderung an dem Schaltungsknotenpunkt N2 einen vorgebbaren Schwellwert, der durch die einzelnen Bauteilwerte definiert ist, überschritten hat.

Sofern sich also eine hinreichend große elektrische Feldverzerrung im Bereich der Messelektrode 122 (Figur 2) ergibt, ändert sich ein Signalzustand des Ausgangssignals an dem Schaltungsknotenpunkt N3, der beispielsweise eine Interrupt-Funktion eines Mikrokontrollers der Steuereinrichtung 110 auslösen kann. Dadurch kann die Steuereinrichtung 110, z.B. ausgehend von einem Energiesparzustand, durch den vorstehend genannten Interrupt beispielsweise in einen Normalbetrieb versetzt werden, in dem die Steuereinrichtung 110 dazu ausgebildet ist, eine Datenkommunikation mit dem Transponder 106b auszuführen.

Figur 4 zeigt eine besonders bevorzugte Ausführungsform einer Bezugspotentialerzeugungsvorrichtung 128. Als Eingangsgrößen werden der Vorrichtung 128 das erste Bezugspotential GND1 und das zweite Bezugspotential VCC zugeführt, wobei diese beispielsweise durch die Batterie 125 (Fig. 1) definiert sind. Über eine Spannungsteilereinrichtung mit den Ohmwiderständen R8, R9 wird eine Mittenspannung, deren Potential zwischen dem ersten Bezugspotential GND1 und dem zweiten Bezugspotential VCC liegt, gebildet, welche durch den Kondensator C4 gegenüber dem ersten Bezugspotential GND1 gepuffert wird.

Sofern die besonders bevorzugten Bauteilwerte R8 = etwa 10 Megaohm und R9 = etwa 10 Megaohm gewählt werden, ergibt sich die dem nichtinvertierenden Eingang des Operationsverstärkers IC3 zugeführte Spannung zu etwa VCC/2, vorliegend also etwa 1,5 Volt. Aufgrund der verhältnismäßig hochohmig gewählten Widerstände R8, R9 ergibt sich auch für die Schaltung 128 gemäß Figur 4 eine außerordentlich geringe elektrische Energieaufnahme.

Der Operationsverstärker IC3 liefert in an sich bekannter Weise eine Ausgangsspannung und stellt auf diese Weise ein stabilisiertes drittes Bezugspotential GND2 bereit.

Bei einer besonders bevorzugten Ausführungsform sind die vorstehend beschriebenen elektronischen Schaltungen zumindest teilweise mittels diskreter Bauelemente realisiert, wodurch sich eine geringe Komplexität und geringe Fertigungskosten ergeben. Die Schaltung 124 (Fig. 3) stellt vorteilhaft einen hochohmigen Messverstärker für das elektrische Feld charakterisierende Signale s_1 (Fig. 2) dar.

Bei einer bevorzugten Ausführungsform können anstelle der Operationsverstärker IC1, IC2, IC3 auch Feldeffekttransistoren oder andere aktive Bauelemente verwendet werden. Bei einer Realisierung mit Operationsverstärkern IC1, IC2, IC3 weisen diese besonders bevorzugt CMOS-Eingänge auf.

Untersuchungen der Anmelderin zufolge kann unter Verwendung des erfindungsgemäßen Prinzips und z.B. der Schaltungstopologie gemäß Figur 3 eine zuverlässig arbeitende Steuerschaltung 120 erhalten werden, welche bei einer Versorgungsspannung von etwa 3,0 Volt eine mittlere Stromaufnahme von nur etwa 1,0 µA (Mikroampere) aufweist. Die Batterie 125 der Schließeinrichtung 100 wird daher in einem Ruhezustand bzw. Energiesparzustand der Steuereinrichtung 110 allein mit nur etwa 1,0 µA Stromaufnahme durch die Steuerschaltung 120 zuzüglich der ebenfalls sehr geringen Stromaufnahme der Steuereinrichtung 110 (typisch etwa <= 1 µA) belastet, wodurch sich eine hohe Lebensdauer der Batterie 125 und dementsprechend lange Serviceintervalle ergeben.

Bei einer besonders bevorzugten Erfindungsvariante ist die Steuerschaltung 120 dazu ausgebildet, das sich durch statische Elektrizität der Umgebung ergebende elektrische Feld zu erfassen, wobei bevorzugt eine Potentialmessung gegenüber dem ersten Bezugspotential GND1 bzw. einem Massepotential der Schaltung 124 erfolgt.

## Patentansprüche

1. Schließeinrichtung (100) mit mindestens einem elektronischen Verbraucher, insbesondere einer Steuereinrichtung (110), aufweisend eine Steuerschaltung (120), die dazu ausgebildet ist, den elektronischen Verbraucher (110) in Abhängigkeit eines elektrischen Feldes von einem ersten Betriebszustand in einen zweiten Betriebszustand zu versetzen, wobei eine Messelektrode (122) zur Detektion des elektrischen Feldes vorgesehen ist und eine Eingangsverstärkereinrichtung (124), welche dazu ausgebildet ist, ein Ausgangssignal (s_1) der Messelektrode (122) zu verstärken, wobei eine Übertragungsfunktion der Eingangsverstärkereinrichtung (124) a) eine Bandpasscharakteristik mit einer Mittenfrequenz von etwa 0,5 Hertz aufweist, oder b) eine Tiefpasscharakteristik mit einer Grenzfrequenz von etwa 1,5 Hertz.

2. Schließeinrichtung (100) nach Anspruch 1, wobei die Steuerschaltung (120) dazu ausgebildet ist, ein elektrisches Feld und/oder eine zeitliche Änderung des elektrischen Felds, insbesondere im Bereich der Schließeinrichtung (100), zu erfassen.

3. Schließeinrichtung (100) nach einem der vorstehenden Ansprüche, wobei die Eingangsverstärkereinrichtung (124) mindestens eine Tiefpassschaltung (T1) aufweist, welche eine Parallelschaltung aus einem kapazitiven Element (C1) und einem resistiven Element (R1) aufweist, wobei vorzugsweise ein Widerstandswert des resistiven Elements (R1) im Bereich von etwa 1 Gigaohm bis etwa 100 Gigaohm liegt, insbesondere im Bereich von etwa 40 Gigaohm bis etwa 60 Gigaohm, und wobei vorzugsweise ein Kapazitätswert des kapazitiven Elements (C1) im Bereich von etwa 0,2 Pikofarad bis etwa 500 Pikofarad liegt, insbesondere im Bereich von etwa 5 Pikofarad bis etwa 20 Pikofarad.

4. Schließeinrichtung (100) nach einem der vorstehenden Ansprüche, wobei eine Auswerteinrichtung (126) vorgesehen ist, welche dazu ausgebildet ist, ein das elektrische Feld und/oder die zeitliche Änderung des elektrischen Felds charakterisierendes Auswertsignal (s_a), auszuwerten, wobei die Auswerteinrichtung (126) insbesondere dazu ausgebildet ist, in Abhängigkeit des Auswertsignals (s_a) ein, insbesondere zweiwertiges, Steuersignal (s_s), auszugeben.

5. Schließeinrichtung (100) nach Anspruch 4, wobei die Auswerteinrichtung (126) eine Diskriminatorschaltung aufweist, wobei die Diskriminatorschaltung eine Serienschaltung aus einem ersten resistiven Element (R5), einer Diodenbrückenschaltung (DB) und einem zweiten resistiven Element (R6) aufweist, wobei die Serienschaltung zwischen einem ersten Bezugspotential (GND1) und einem zweiten Bezugspotential (VCC) angeschlossen ist.

6. Schließeinrichtung (100) nach Anspruch 5, wobei die Diodenbrückenschaltung (DB) eine Parallelschaltung aufweist aus zwei jeweils zwei Dioden (D1, D3, D2, D4) aufweisenden Diodenserienschaltungen, wobei einem Schaltungsknoten (N2) zwischen den Dioden (D1, D3) einer ersten der beiden Diodenserienschaltungen das Auswertsignal (s_a) zugeführt ist, und wobei ein Schaltungsknoten (N4) zwischen den Dioden (D2, D4) einer zweiten der beiden Diodenserienschaltungen mit einem dritten Bezugspotential (GND2) verbunden ist.

7. Schließeinrichtung (100) nach einem der Ansprüche 5 bis 6, wobei die Diodenbrückenschaltung (DB) zwischen dem ersten resistiven Element (R5) und dem zweiten resistiven Element (R6) geschaltet ist.

8. Schließeinrichtung (100) nach einem der Ansprüche 5 bis 7, wobei eine Verstärkereinrichtung (IC2) mit ihrem Eingang parallel zu der Diodenbrückenschaltung (DB) geschaltet ist.

9. Schließeinrichtung (100) nach einem der Ansprüche 5 bis 8, wobei das erste und/oder zweite resistive Element (R5, R6) einen Widerstandswert von mindestens etwa 1 Megaohm aufweist, vorzugsweise von mindestens etwa 10 Megaohm.

10. Schließeinrichtung (100) nach einem der vorstehenden Ansprüche, wobei eine Bezugspotentialerzeugungsvorrichtung (128) vorgesehen ist, welche dazu ausgebildet ist, mindestens ein drittes elektrisches Bezugspotential (GND2) in Abhängigkeit eines ersten und zweiten elektrischen Bezugspotentials (GND1, VCC) bereitzustellen.

11. Schließeinrichtung (100) nach Anspruch 10, wobei die Bezugspotentialerzeugungsvorrichtung (128) eine Serienschaltung aus mindestens zwei resistiven Elementen (R8, R9) aufweist, wobei das erste und/oder zweite resistive Element (R8, R9) der Bezugspotentialerzeugungsvorrichtung (128) einen Widerstandswert von mindestens etwa 1 Megaohm aufweist, vorzugsweise von mindestens etwa 10 Megaohm.

12. Verfahren zum Betreiben einer Schließeinrichtung (100) mit mindestens einem elektronischen Verbraucher, insbesondere einer Steuereinrichtung (110), wobei eine Steuerschaltung (120) vorgesehen ist, die den elektronischen Verbraucher (110) in Abhängigkeit eines elektrischen Feldes von einem ersten Betriebszustand in einen zweiten Betriebszustand versetzt, wobei eine Messelektrode (122) zur Detektion des elektrischen Feldes vorgesehen ist und eine Eingangsverstärkereinrichtung (124), welche ein Ausgangssignal (s_1) der Messelektrode (122) verstärkt, wobei eine Übertragungsfunktion der Eingangsverstärkereinrichtung (124) a) eine Bandpasscharakteristik mit einer Mittenfrequenz von etwa 0,5 Hertz aufweist, oder b) eine Tiefpasscharakteristik mit einer Grenzfrequenz von etwa 1,5 Hertz.

13. Verfahren nach Anspruch 12, wobei die Steuerschaltung (120) ein elektrisches Feld und/oder eine zeitliche Änderung des elektrischen Felds, insbesondere im Bereich der Schließeinrichtung (100), erfasst.

## Claims

1. A locking device (100) having at least one electronic load, in particular a control device (110), and comprising a control circuit (120) which is designed to transfer the electronic load (110) from a first operating state to a second operating state depending on an electric field, wherein a measuring electrode (122) for detecting the electric field and an input amplifier device (124) adapted to amplify an output signal (s_1) of the measuring electrode (122) are provided, wherein a transfer function of the input amplifier device (124) has a) a band-pass characteristic with a center frequency of about 0.5 Hertz, or b) a low-pass characteristic with a cut-off frequency of about 1.5 Hertz.

2. The locking device (100) according to claim 1, wherein the control circuit (120) is adapted to detect at least one of an electric field and a temporal variation in the electric field, in particular in the area of the locking device (100).

3. The locking device (100) according to one of the preceding claims, wherein the input amplifier device (124) comprises at least one low-pass circuit (T1) which comprises a parallel circuit of a capacitive element (C1) and a resistive element (R1), wherein a resistance value of the resistive element (R1) preferably is in the range of about 1 gigaohm to about 100 gigaohm, in particular in the range of about 40 gigaohm to about 60 gigaohm, and wherein preferably a capacitance value of the capacitive element (C1) is in the range of about 0.2 picofarad to about 500 picofarad, in particular in the range of about 5 picofarad to about 20 picofarad.

4. The locking device (100) according to one of the preceding claims, wherein an evaluation device (126) is provided which is adapted to evaluate an evaluation signal (s_a) characterizing at least one of the electric field and the temporal variation in the electric field, wherein the evaluation device (126) is adapted in particular to output, depending on the evaluation signal (s_a), a control signal (s_s), in particular a binary control signal (s_s).

5. The locking device (100) according to claim 4, wherein the evaluation device (126) comprises a discriminator circuit, wherein the discriminator circuit comprises a series circuit of a first resistive element (R5), a diode bridge circuit (DB) and a second resistive element (R6), wherein the series circuit is connected between a first reference potential (GND1) and a second reference potential (VCC).

6. The locking device (100) according to claim 5, wherein the diode bridge circuit (DB) comprises a parallel circuit of two diode series circuits each comprising two diodes (D1, D3, D2, D4), wherein the evaluation signal (s_a) is supplied to a circuit node (N2) between the diodes (D1, D3) of a first one of the two diode series circuits, and wherein a circuit node (N4) between the diodes (D2, D4) of a second one of the two diode series circuits is connected to a third reference potential (GND2).

7. The locking device (100) according to one of the claims 5 to 6, wherein the diode bridge circuit (DB) is connected between the first resistive element (R5) and the second resistive element (R6).

8. The locking device (100) according to one of the claims 5 to 7, wherein an input of an amplifier device (IC2) is connected in parallel with the diode bridge circuit (DB).

9. The locking device (100) according to one of the claims 5 to 8, wherein at least one of the first and second resistive elements (R5, R6) has a resistance value of at least about 1 megaohm, preferably at least about 10 megaohm.

10. The locking device (100) according to one of the preceding claims, wherein a reference potential generating device (128) is provided, which is adapted to provide at least a third electrical reference potential (GND2) depending on first and second electrical reference potentials (GND1, VCC).

11. The locking device (100) according to claim 10, wherein the reference potential generating device (128) comprises a series circuit of at least two resistive elements (R8, R9), wherein at least one of the first and second resistive elements (R8, R9) of the reference potential generating device (128) has a resistance value of at least about 1 megaohm, preferably at least about 10 megaohm.

12. A method for operating a locking device (100) with at least one electronic load, in particular a control device (110), wherein a control circuit (120) is provided which transfers the electronic load (110) from a first operating state to a second operating state depending on an electric field, wherein a measuring electrode (122) for detecting the electric field and an input amplifier device (124) amplifying an output signal (s_1) of the measuring electrode (122) are provided, wherein a transfer function of the input amplifier device (124) has a) a bandpass characteristic with a center frequency of about 0.5 Hertz, or b) a low-pass characteristic with a cut-off frequency of about 1.5 Hertz.

13. The method according to claim 12, wherein the control circuit (120) detects at least one of an electric field and a temporal variation in the electric field, in particular in the area of the locking device (100).

## Revendications

1. Dispositif de fermeture (100) comprenant au moins un dispositif consommateur électronique, en particulier un dispositif de commande (110), présentant un circuit de commande (120) qui est conçu pour faire passer ledit dispositif consommateur électronique (110) d'un premier état de fonctionnement à un deuxième état de fonctionnement en fonction d'un champ électrique, dans lequel on prévoit une électrode de mesure (122) pour la détection du champ électrique ainsi qu'un dispositif amplificateur d'entrée (124) qui est conçu pour amplifier un signal de sortie (s_1) de l'électrode de mesure (122), dans lequel une fonction de transfert du dispositif amplificateur d'entrée (124) comprend a) une caractéristique passe-bande avec une fréquence centrale de 0,5 Hertz à peu près, ou b) une caractéristique passe-bas avec une fréquence de coupure de 1,5 Hertz à peu près.

2. Dispositif de fermeture (100) selon la revendication 1, dans lequel le circuit de commande (120) est conçu pour détecter un champ électrique et/ou une variation du champ électrique dans le temps, en particulier au niveau du dispositif de fermeture (100).

3. Dispositif de fermeture (100) selon l'une quelconque des revendications précédentes, dans lequel le dispositif amplificateur d'entrée (124) comprend au moins un circuit passe-bas (T1) qui présente un montage en parallèle d'un élément capacitif (C1) et d'un élément résistif (R1), dans lequel, de préférence, une valeur de résistance de l'élément résistif (R1) se situe dans la plage allant d'environ 1 gigaohm à environ 100 gigaohms, en particulier dans la plage allant d'environ 40 gigaohms à environ 60 gigaohms, et dans lequel, de préférence, une valeur de capacité de l'élément capacitif (C1) se situe dans la plage allant d'environ 0,2 picofarad à environ 500 picofarads, en particulier dans la plage allant d'environ 5 picofarads à environ 20 picofarads.

4. Dispositif de fermeture (100) selon l'une quelconque des revendications précédentes, dans lequel un dispositif d'évaluation (126) est prévu qui est conçu pour évaluer un signal d'évaluation (s_a) caractérisant le champ électrique et/ou la variation du champ électrique dans le temps, dans lequel le dispositif d'évaluation (126) est conçu en particulier pour délivrer un signal de commande (s_s), en particulier à deux valeurs, en fonction du signal d'évaluation (s_a).

5. Dispositif de fermeture (100) selon la revendication 4, dans lequel le dispositif d'évaluation (126) comprend un circuit discriminateur, le circuit discriminateur présentant un montage en série d'un premier élément résistif (R5), d'un circuit en pont de diodes (DB) et d'un deuxième élément résistif (R6), dans lequel le montage en série est raccordé entre un premier potentiel de référence (GND1) et un deuxième potentiel de référence (VCC).

6. Dispositif de fermeture (100) selon la revendication 5, dans lequel le circuit en pont de diodes (DB) comprend un montage en parallèle de deux montages en série de diodes comprenant chacun deux diodes (D1, D3, D2, D4), dans lequel le signal d'évaluation (s_a) est fourni à un nœud de circuit (N2) entre les diodes (D1, D3) d'un premier des deux montages en série de diodes, et dans lequel un nœud de circuit (N4) entre les diodes (D2, D4) d'un deuxième des deux montages en série de diodes est relié à un troisième potentiel de référence (GND2).

7. Dispositif de fermeture (100) selon l'une quelconque des revendications 5 à 6, dans lequel le circuit en pont de diodes (DB) est connecté entre le premier élément résistif (R5) et le deuxième élément résistif (R6).

8. Dispositif de fermeture (100) selon l'une quelconque des revendications 5 à 7, dans lequel l'entrée d'un dispositif amplificateur (IC2) est connectée en parallèle au circuit en pont de diodes (DB).

9. Dispositif de fermeture (100) selon l'une quelconque des revendications 5 à 8, dans lequel le premier et/ou le deuxième élément résistif (R5, R6) présente une valeur de résistance d'au moins 1 mégohm à peu près, de préférence d'au moins 10 mégohms à peu près.

10. Dispositif de fermeture (100) selon l'une quelconque des revendications précédentes, dans lequel un dispositif générateur de potentiel de référence (128) est prévu qui est conçu pour fournir au moins un troisième potentiel électrique de référence (GND2) en fonction d'un premier et d'un deuxième potentiel électrique de référence (GND1, VCC) .

11. Dispositif de fermeture (100) selon la revendication 10, dans lequel le dispositif générateur de potentiel de référence (128) comprend un montage en série d'au moins deux éléments résistifs (R8, R9), dans lequel le premier et/ou le deuxième élément résistif (R8, R9) du dispositif générateur de potentiel de référence (128) présente une valeur de résistance d'au moins 1 mégohm à peu près, de préférence d'au moins 10 mégohms à peu près.

12. Procédé destiné à faire fonctionner un dispositif de fermeture (100) comprenant au moins un dispositif consommateur électronique, en particulier un dispositif de commande (110), dans lequel un circuit de commande (120) est prévu qui fait passer ledit dispositif consommateur électronique (110) d'un premier état de fonctionnement à un deuxième état de fonctionnement en fonction d'un champ électrique, dans lequel on prévoit une électrode de mesure (122) pour la détection du champ électrique ainsi qu'un dispositif amplificateur d'entrée (124) qui amplifie un signal de sortie (s_1) de l'électrode de mesure (122), dans lequel une fonction de transfert du dispositif amplificateur d'entrée (124) comprend a) une caractéristique passe-bande avec une fréquence centrale de 0,5 Hertz à peu près, ou b) une caractéristique passe-bas avec une fréquence de coupure de 1,5 Hertz à peu près.

13. Procédé selon la revendication 12, dans lequel le circuit de commande (120) détecte un champ électrique et/ou une variation du champ électrique dans le temps, en particulier au niveau du dispositif de fermeture (100).
